# FASCICULE DE BREVET EUROPEEN

(11) **EP 1 210 730 B1**
(45) Date de publication et mention de la délivrance du brevet: **10.11.2010**
(21) Numéro de dépôt: 00960820.9
(22) Date de dépôt: 07.09.2000
(51) Int. Cl.: H01L 21/18, H01L 21/04, H01L 21/76

(54) **REALISATION D'UN COLLAGE ELECTRIQUEMENT CONDUCTEUR ENTRE DEUX ELEMENTS SEMI-CONDUCTEURS**
HERSTELLUNG EINER LEITENDEN VERBINDUNG ZWISCHEN ZWEI HALBLEITERELEMENTEN
METHOD FOR ELECTRICALLY CONDUCTIVE BONDING BETWEEN TWO SEMICONDUCTOR ELEMENTS

(30) Priorité: 08.09.1999 FR 9911224
(43) Date de publication de la demande: 05.06.2002
(73) Titulaire: Commissariat à l'Énergie Atomique et aux Énergies Alternatives, 75015 Paris (FR)
(72) Inventeur: JAUSSAUD, Claude, F-38240 Meylan (FR); JALAGUIER, Eric, F-38410 Saint-Martin-d'Uriage (FR); MADAR, Roland, F-38320 Eybens (FR)
(74) Mandataire: Collin, Jérôme
(86) Numéro de dépôt international: PCT/FR2000/002468
(87) Numéro de publication internationale: WO 2001/018853

(56) Documents cités:
- EP-A- 0 587 996
- US-A- 5 441 911
- SHIEH C L ET AL: "A 1.3 mu m InGaAsP ridge waveguide laser on GaAs and silicon substrates by thin-film transfer" THIRD INTERNATIONAL CONFERENCE ON INDIUM PHOSPHIDE AND RELATED MATERIALS, CARDIFF, UK, 8 - 11 avril 1991, pages 272-275, XP002140746 IEEE, New York, USA ISBN: 0-87942-626-8
- LU Y ET AL: "Eutectic bonding for inducing in-plane strain in GaAs and GaAs-AlGaAs MQW thin films" ADVANCED METALLIZATION FOR DEVICES AND CIRCUITS - SCIENCE, TECHNOLOGY AND MANUFACTURABILITY SYMPOSIUM, SAN FRANCISCO, CA, USA, 4 - 8 avril 1994, pages 607-612, XP000921252 Mater. Res. Soc, Pittsburgh, PA, USA
- WOLFFENBUTTEL R F: "Low-temperature intermediate Au-Si wafer bonding; eutectic or silicide bond" SENSORS AND ACTUATORS A (PHYSICAL), vol. A62, no. 1-3, juillet 1997 (1997-07), pages 680-686, XP004119709 Elsevier, Switzerland ISSN: 0924-4247

## Description

### Domaine technique

La présente invention concerne un procédé permettant la réalisation d'un collage électriquement conducteur entre deux éléments semi-conducteurs.

### Etat de la technique antérieure

Le report d'un film mince de matériau semi-conducteur sur un support est souvent utilisé dans le domaine de la microélectronique. C'est le cas notamment pour les dispositifs élaborés sur GaAs pour lesquels il est préférable de disposer d'un substrat constitué d'un film mince de GaAs sur un support en silicium. Cette solution apporte plusieurs avantages. Elle permet de réduire les coûts puisque le GaAs est un matériau cher par rapport au silicium. Elle permet de simplifier la mise en oeuvre puisque le GaAs est fragile et donc délicat à manipuler. Elle permet aussi de réduire le poids des composants, ce qui est un paramètre important pour les applications spatiales, puisque le silicium est plus léger que le GaAs.

Un tel report se fait de façon classique par collage par l'intermédiaire d'un oxyde, ce type de collage étant bien maîtrisé. Cependant, ce collage au moyen d'un oxyde présente la particularité d'isoler électriquement le film mince de son support. Or, pour certaines applications, il est nécessaire d'établir une conduction électrique verticale au travers du substrat. C'est le cas notamment des diodes élaborées sur un film de SiC formé sur un support en silicium et des cellules solaires réalisées par dépôt de GaAs sur du silicium.

Par ailleurs, certains types de transistors (par exemple les transistors à base perméable ou à base métallique) nécessitent d'avoir une couche métallique enterrée sous la couche de semi-conducteur à partir de laquelle ils sont élaborés. Ce type de couche est difficile à réaliser et le collage conducteur est la solution la plus simple pour réaliser ce type de structure.

Plusieurs solutions ont été proposées pour réaliser un collage conducteur de deux plaques de silicium. On peut citer l'article "Buried Cobalt Silicide layers in Silicon Created by Wafer Bonding" de K. LJUNGBERG et al., paru dans J. Electrochem. Soc., Vol. 141, No 10, octobre 1994, pages 2829-2833 et l'article "Low Temperature Silicon Wafer-to-Wafer Bonding with Nickel Silicide" de Zhi-Xiong Xiao et al., paru dans J. Electrochem. Soc., Vol. 145, No 4, avril 1998, pages 1360-1362. Toutes ces solutions consistent à former, à partir d'un métal déposé sur les faces des plaques à coller, un siliciure par réaction du métal et du matériau semi-conducteur. Ces solutions présentent deux inconvénients. D'une part, la formation de siliciure consomme une partie du film semi-conducteur, ce qui peut être un inconvénient dans le cas de films très minces. D'autres part, il y a diffusion du métal dans le semi-conducteur, ce qui a pour conséquence de dégrader ses propriétés. C'est en particulier le cas si on utilise du nickel. De plus, les composés formés ne sont pas stables à haute température, ce qui limite les possibilités de traitement thermique après réalisation du collage. Ces deux aspects peuvent être très importants si l'on désire, après le collage, effectuer une épitaxie qui peut mettre en oeuvre des températures élevées (de l'ordre de 1600°C dans le cas du SiC).

Le document WOLFFENBUTTEL R F: "Low-temperature intermediate Au-Si wafer bonding; eutectic or silicide bond" SENSORS AND ACTUATORS A (PHYSICAL), vol. A62, no. 1-3, juillet 1997 (1997-07), pages 680-686, XP004119709 Elsevier, Switzerland ISSN: 0924-4247
décrit un procédé de réalisation d'un collage électriquement conducteur entre une face d'un premier élément semi-conducteur en Si et une face d'un deuxième élément semi-conducteur en Si au moyen d'un traitement thermique, consistant à
- déposer une couche de SiO₂/Ti/Au/Si/Au sur la face du premier élément semi-conducteur et sur la face du deuxième élément semi-conducteur, ces couches déposées se combinant lors dudit traitement thermique pour constituer une couche assurant un collage électriquement conducteur entre les deux faces,
- appliquer lesdites faces l'une contre l'autre avec interposition desdites couches de matériau déposées et réaliser ledit traitement thermique à une température égal à 800°C.

### Exposé de l'intention

Afin de remédier aux inconvénients cités ci-dessus, il est proposé selon la présente invention d'utiliser un collage par l'intermédiaire d'une ou de plusieurs couches ne réagissant pas avec au moins l'un des deux matériaux semi-conducteurs à relier électriquement.

L'invention a donc pour objet un procédé de réalisation d'un collage électriquement conducteur entre une face d'un premier élément semi-conducteur en SiC et une face d'un deuxième élément semi-conducteur en SiC au moyen d'un traitement thermique, défini par la revendication 1.

Selon un mode particulier de mise en oeuvre, l'une des couches de matériau est déposée avec une surépaisseur telle qu'une partie de cette couche, en contact avec l'autre couche de matériau, se combine avec l'autre couche de matériau déposée pour former ledit mélange stable, l'autre partie de la couche déposée avec une surépaisseur, en contact avec l'élément semi-conducteur sur lequel elle est déposée réagissant lors du traitement thermique avec cet élément semi-conducteur pour former un film de contact ohmique.

Il peut être prévu une couche d'oxyde entre les couches de matériau déposées, l'oxyde étant choisi pour réagir avec au moins un matériau desdites couches déposées, les épaisseurs de la couche d'oxyde et de la couche de matériau avec lequel l'oxyde réagit étant telles que l'oxyde formé se présente sous la forme de précipités isolés qui n'altèrent pas sensiblement le collage électriquement conducteur. Cette couche d'oxyde peut être déposée sur l'une des couches de matériau déposées ou sur les deux, par exemple par une méthode choisie parmi le dépôt sous vide et le dépôt de type sol-gel.

Pour améliorer le collage, les premier et deuxième éléments semi-conducteurs peuvent être pressés l'un contre l'autre lors du traitement thermique.

Si l'un des éléments semi-conducteurs est un film mince en SiC, le procédé peut comprendre une étape préliminaire consistant à définir ce film mince comme couche superficielle d'un substrat, destinée à être séparée du reste du substrat. Selon un premier exemple de réalisation, lors de l'étape préliminaire, le substrat est formé par empilement d'un support, d'une couche sacrificielle et du film mince, la séparation du film mince du reste du substrat étant obtenue, après réalisation du collage, par dissolution de la couche sacrificielle. Selon un deuxième exemple de réalisation, lors de l'étape préliminaire, le film mince est délimité dans un substrat par une couche de microcavités obtenue par implantation ionique, la séparation du film mince du reste du substrat étant consécutive au traitement thermique de collage ou à un traitement thermique spécifique ou encore à l'application de forces mécaniques ou à la combinaison d'un traitement thermique et de l'application de forces mécaniques.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1D illustrent un premier exemple de réalisation d'un collage électriquement conducteur entre deux éléments semi-conducteurs, selon le procédé de l'invention,
- les figures 2A à 2E illustrent un deuxième exemple de réalisation d'un collage électriquement conducteur entre deux éléments semi-conducteurs, selon le procédé de l'invention,
- les figures 3A à 3D illustrent un troisième exemple de réalisation d'un collage électriquement conducteur entre deux éléments semi-conducteurs, selon le procédé de l'invention.

### Description détaillée de modes de réalisation de l'invention

L'invention propose de réaliser un collage par l'intermédiaire de couches qui ne réagissent pas avec l'un ou l'autre des éléments semi-conducteurs à relier électriquement.

Selon l'invention, les matériaux interposés entre les deux éléments à coller réagissent lors du traitement thermique pour former un mélange stable vis-à-vis de ces éléments à des températures importantes et notamment supérieures à celle du traitement thermique. Cette stabilité à haute température est particulièrement importante lorsque les éléments sont en SiC et que l'un d'entre eux doit subir une épitaxie.

Le procédé selon l'invention ne nécessite pas l'utilisation d'une barrière de diffusion bien qu'une barrière de diffusion puisse être quand même utilisée.

Préférentiellement, les matériaux interposés sont :
- W (ou composé à base de W)/Si,
- W (ou un composé à base de W)/Si/W (ou un composé à base de W).

Les épaisseurs des couches interposées sont généralement paramétrées pour que la totalité des matériaux de ces couches interagissent pour former un nouveau matériau stable. Cependant, dans certains cas, il peut être avantageux d'utiliser au moins une couche de matériau présentant une surépaisseur. Cette surépaisseur de matériau réagit alors lors du traitement thermique à haute température avec l'élément avec lequel elle est en contact pour former un film de contact ohmique.

A titre d'exemple, pour des éléments à coller en SiC et des couches interposées en W et Si, pour que la totalité des couches interposées réagisse, le rapport de l'épaisseur totale de la ou des couches de Si avec l'épaisseur totale de la ou des couches de W doit être égal ou voisin de 2,5 pour obtenir une couche homogène de WSi₂. Pour disposer d'une surépaisseur apte à réagir, il faut se placer légèrement en dessous de 2,5. Ceci permet d'avoir un film mince à base de WSi et WC qui est stable aussi à haute température.

Selon une approche cinétique, on utilise des couches qui ne sont stables thermo-dynamiquement avec l'un ou l'autre des matériaux semi-conducteurs aux températures utilisées lors de la réalisation des dispositifs, et lors de leur utilisation, qu'après le traitement thermique de collage des deux éléments semi-conducteurs. Par exemple, dans le cas du report de carbure de silicium sur du carbure de silicium, on peut utiliser les empilements suivants : élément en SiC/couche de W/couche de Si-couche de Si/couche de W/SiC, le silicium pouvant être amorphe ou cristallin. Lors du traitement thermique, le tungstène réagit avec le silicium pour former du WSi₂. Pour une structure SiC/W (épaisseur 0,1 µm)/Si (épaisseur 0,25 µm)-Si(épaisseur 0,25 µm)/W(épaisseur 0,1 µm)/SiC, on obtient SiC/WSi₂/SiC. La réaction se produit à partir de 650°C, en impliquant la réaction du silicium avec le tungstène, sans consommation du film mince de SiC et le système est stable à plus de 1600°C.

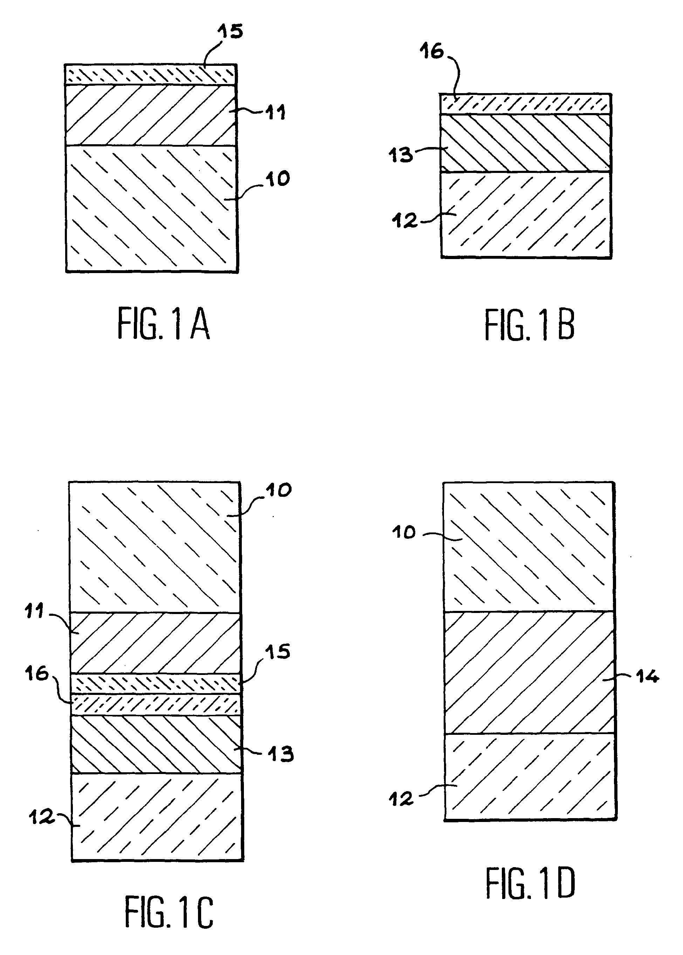

Les figures 1A à 1D sont des vues transversales qui illustrent un premier exemple de mise en oeuvre du procédé selon l'invention pour lequel le collage est réalisé selon une approche cinétique. La figure 1A montre une plaque 10 en SiC recouverte successivement d'une couche 11 de tungstène et d'une couche 15 de silicium. La figure 1B montre une plaque 12 de SiC recouverte successivement d'une couche 13 de tungstène et d'une couche 16 de silicium. La figure 1C montre l'association des structures représentées aux figures 1A et 1B, ces structures étant mises en contact par leurs couches 15 et 16. Après traitement thermique à partir de 650°C, on obtient l'assemblage représenté à la figure 1D. La plaque 10 en SiC est reliée par un collage électriquement conducteur à la plaque 12 en SiC grâce à la couche intermédiaire 14 formée entre les deux plaques et comprenant du WSi₂.

Un tel collage électriquement conducteur peut être utilisé pour coller un film mince semi-conducteur sur un support semi-conducteur. Afin d'obtenir ce film mince on peut réduire l'épaisseur de l'une des deux plaques collées. Ceci présente deux inconvénients majeurs. D'une part il est difficile d'obtenir un film mince homogène en épaisseur et, d'autre part, il y a perte du reste de plaque semi-conductrice fournissant ce film. La présente invention permet également de remédier à ces inconvénients. Une première solution met en oeuvre une couche sacrificielle. Une seconde solution met en oeuvre une méthode de clivage après implantation ionique.

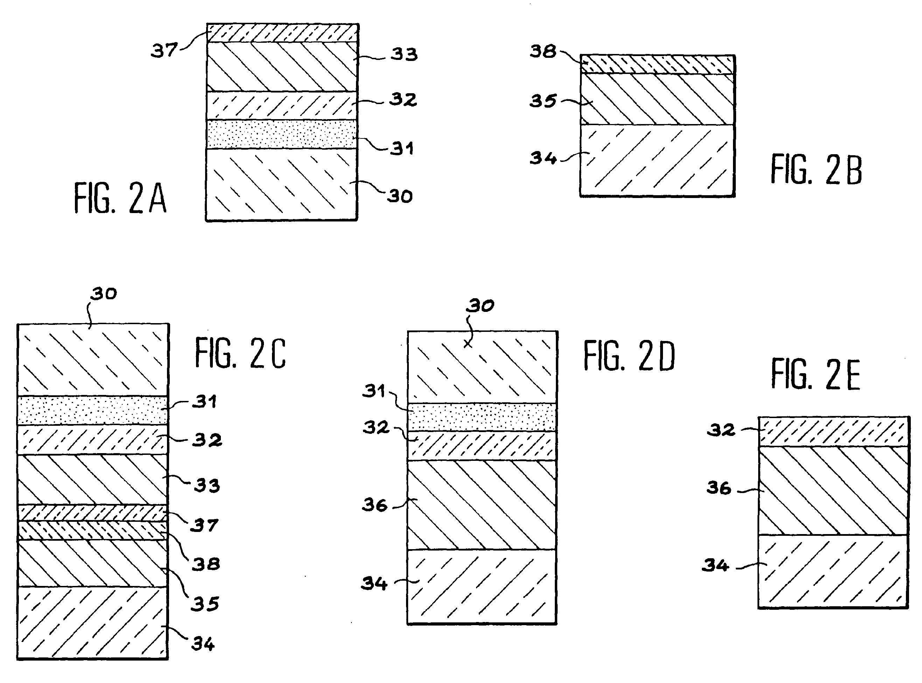

Les figures 2A à 2E sont des vues transversales qui illustrent la réalisation d'un collage électriquement conducteur, selon une approche cinétique, entre une plaque semi-conductrice de SiC et un film mince en SiC obtenu par dissolution d'une couche sacrificielle. La figure 2A montre une plaque 30 en silicium recouverte d'une couche 31 d'oxyde ou de nitrure de silicium qui servira de couche sacrificielle. La couche sacrificielle 31 est recouverte successivement d'une couche 32 en SiC, qui fournira le film mince, d'une couche 33 de tungstène et d'une couche 37 de silicium. La figure 2B montre une plaque 34 de SiC recouverte d'une couche 35 en tungstène et d'une couche 38 en silicium. La figure 2C montre l'association des structures représentées aux figures 2A et 2B, ces structures étant mises en contact par leurs couches 37 et 38. Après traitement thermique à partir de 650°C, on obtient l'assemblage représenté à la figure 2D. La couche 32 en SiC est reliée par un collage électriquement conducteur à la plaque 34 en SiC grâce à la couche intermédiaire 36 constituée de WSi₂. La couche sacrificielle est ensuite dissoute par une technique connue de l'homme de l'art. On obtient d'une part la structure représentée à la figure 2E, c'est-à-dire un film mince de SiC collé par une liaison électrique à un support en SiC, et d'autre part une plaque de silicium réutilisable.

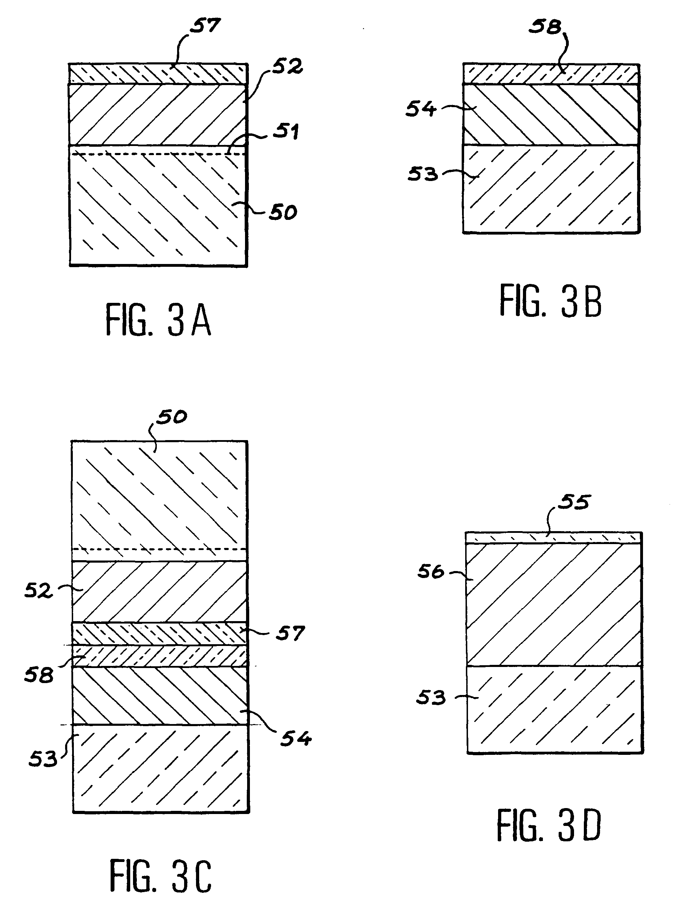

Les figures 3A à 3D sont des vues transversales qui illustrent la réalisation d'un collage électriquement conducteur, selon une approche cinétique, entre une plaque semi-conductrice de SiC et un film mince en SiC obtenu par clivage après implantation ionique. La figure 3A montre une plaque 50 en SiC dans laquelle une couche 51 de microcavités a été engendrée par implantation ionique, au travers de l'une des faces de la plaque 50, selon la technique divulguée par le document FR-A-2 681 472. Une couche 52 de tungstène et une couche 57 de silicium ont été successivement déposées sur la face implantée de la plaque 50. La figure 3B montre une plaque 53 de SiC recouverte d'une couche 54 en tungstène et d'une couche 58 en silicium. La figure 3C montre l'association .des structures représentées aux figures 3A et 3B, ces structures étant mises en contact par leurs couches 57 et 58. Après traitement thermique, on obtient l'assemblage représenté à la figure 3D. Le traitement thermique a provoqué le clivage de la plaque 50 le long de la couche de microcavités. Il subsiste un film mince 55 de SiC relié par un collage électriquement conducteur à la plaque 53 en SiC grâce à la couche intermédiaire 56 comprenant du WSi₂. Le reste de la plaque 50 peut alors être réutilisé.

De façon avantageuse, afin d'améliorer le collage, on peut appliquer une pression entre les structures assemblées. On peut aussi, conjointement ou non, utiliser une fine couche d'oxyde sur la surface d'au moins l'une des structures pour diminuer la pression nécessaire pour le collage, voire l'annuler. Cette couche d'oxyde doit être suffisamment fine (quelques angströms) et apte à interagir avec au moins l'un des matériaux de collage pour former à l'issue du procédé des précipités qui ne feront pas obstacle à la conduction électrique. Lors du traitement thermique, la fine couche d'oxyde réagit avec le métal qui lui est présenté, si celui-ci est suffisamment électropositif, pour former des oxydes métalliques qui se présentent sous la forme de précipités isolés. C'est en particulier le cas du titane qui réagit avec l'oxyde SiO₂ pour former TiO₂ en libérant du silicium. Ainsi, un empilement SiC/SiO₂ (de 0,01 µm d'épaisseur)-SiO₂ (de 0,01 µm d'épaisseur)/Ti (de 0,1 µm d'épaisseur)/Si fournit la structure SiC/(TiSi₂ + TiOₓ)/Si. La réaction se produit à 1000°C, en impliquant la réaction du silicium avec le titane et la réduction du SiO₂ par le titane, sans consommation du film mince de SiC. Le SiO₂ doit être mince pour que le TiO₂ ne forme pas de couche continue. Le système est stable jusqu'à 1330°C (limité par la formation d'un eutectique entre TiSi₂ et Si à cette température).

La description faite ci-dessus peut s'appliquer au collage d'autres éléments. Ainsi par exemple on peut coller une couche de GaN épitaxiée sur un substrat de saphir ou de SiC avec un substrat de SiC en interposant au moins deux couches de matériaux, respectivement de W et de Si.

## Revendications

1. Procédé de réalisation d'un collage électriquement conducteur entre une face d'un premier élément semi-conducteur en SiC (10, 30, 55) et une face d'un deuxième élément semi-conducteur en SiC (12, 34, 53) au moyen d'un traitement thermique, consistant à déposer au moins une couche de Tungstène et une couche de Silicium sur la face du premier élément semi-conducteur et sur la face du deuxième élément semi-conducteur ;
- appliquer lesdites faces l'une contre l'autre avec interposition desdites couches de matériau déposées;
- réaliser ledit traitement thermique à une température supérieure ou égale à 650°C ;
les couches déposées se combinant lors du traitement thermique pour constituer une couche assurant un collage électriquement conducteur entre les deux faces, les couches (11, 15, 33, 37, 52, 57) déposées sur ladite face du premier élément semi-conducteur et les couches (13, 16, 35, 38, 54, 58) déposées sur ladite face du deuxième élément semi-conducteur sont choisies pour réagir en phase solide lors du traitement thermique et former un mélange stable en température respectivement vis-à-vis du premier (10, 32, 55) et du deuxième (12, 34, 53) élément semi-conducteur, le traitement thermique n'induisant pas de produit de réaction entre les matériaux déposés et au moins l'un des éléments semiconducteurs.

2. Procédé selon la revendication 1, **caractérisé en ce que** l'une des couches de matériau est déposée avec une surépaisseur telle qu'une partie de cette couche, en contact avec l'autre couche de matériau, se combine avec l'autre couche de matériau déposée pour former ledit mélange stable, l'autre partie de la couche déposée avec une surépaisseur, en contact avec l'élément semi-conducteur sur lequel elle est déposée, réagissant lors du traitement thermique avec cet élément semi-conducteur pour former un film de contact ohmique.

3. Procédé selon la revendication 1, **caractérisé en ce qu'**il est prévu une couche d'oxyde entre lesdites couches de matériau déposées, l'oxyde étant choisi pour réagir avec au moins un matériau desdites couches déposées, les épaisseurs de la couche d'oxyde et de la couche de matériau avec lequel l'oxyde réagit étant telles que l'oxyde formé se présente sous la forme de précipités isolés qui n'altèrent pas sensiblement le collage électriquement conducteur.

4. Procédé selon la revendication 3, **caractérisé en ce que** ladite couche d'oxyde est déposée sur l'une des couches de matériau déposées ou sur les deux.

5. Procédé selon la revendication 1, **caractérisé en ce que** les premier et deuxième éléments semi-conducteurs sont pressés l'un contre l'autre lors du traitement thermique.

6. Procédé selon l'une quelconque des revendications précédentes, **caractérisé en ce que**, l'un des éléments semi-conducteurs étant un film mince en SiC (32, 55), le procédé comprend une étape préliminaire consistant à définir ce film mince comme couche superficielle d'un substrat, destinée à être séparée du reste du substrat.

7. Procédé selon la revendication 6, **caractérisé en ce que**, lors de l'étape préliminaire, le substrat est formé par empilement d'un support (30), d'une couche sacrificielle (31) et du film mince (32), la séparation du film mince du reste du substrat étant obtenue, après réalisation du collage, par dissolution de la couche sacrificielle (31).

8. Procédé selon la revendication 6, **caractérisé en ce que**, lors de l'étape préliminaire, le film mince est délimité dans un substrat (50) par une couche de microcavités (51) obtenue par implantation ionique, la séparation du film mince du reste du substrat étant consécutive au traitement thermique de collage ou à un traitement thermique spécifique ou encore à l'application de forces mécaniques ou à la combinaison d'un traitement thermique et de l'application de forces mécaniques.

## Claims

1. A process for carrying out electrically conductive bonding between a face of a first SiC semiconductor element (10, 32, 55) and a face of a second SiC semiconductor element (12, 34, 53) by means of thermal treatment, consisting of depositing at least one layer of tungsten and a layer of silicon to the face of the first semiconductor element and to the face of the second semiconductor element;
- applying said faces to one another with interposition of said deposited layers of material,
- carrying out said thermal treatment at a temperature greater than or equal to 650°C,
the deposited layers combining during thermal treatment to constitute a layer ensuring electrically conductive bonding between the two faces, the layers (11, 15, 33, 37, 52, 57) deposited on said face of the first semiconductor element and the layers (13, 16, 35, 38, 54, 58) deposited on said face of the second semiconductor element are selected to react in solid phase during thermal treatment and form a mixture stable in temperature respectively vis-à-vis the first (10, 32, 55) and the second (12, 34, 53) semiconductor element, the thermal treatment not causing a reaction product between the deposited materials and at least one of the semiconductor elements.

2. The process as claimed in Claim 1, **characterised in that** one of the layers of material is deposited with an excess thickness such as part of this layer in contact with the other layer of material and combines with the other layer of material deposited to form said stable mixture, the other part of the deposited layer with an excess thickness in contact with the semiconductor element on which it is deposited then reacting during thermal treatment with this semiconductor element to form an ohmic contact film.

3. The process as claimed in Claim 1, **characterised in that** a layer of oxide is provided between said deposited layers of material, the oxide being selected to react with at least one material of said deposited layers, the thicknesses of the layer of oxide and the layer of material with which the oxide reacts being such that the oxide formed is in the form of insulated precipitates which do not substantially alter the electrically conductive bonding.

4. The process as claimed in Claim 3, **characterised in that** said layer of oxide is deposited on one of the deposited layers of material or on both.

5. The process as claimed in Claim 1, **characterised in that** the first and second semiconductor elements are pressed against one another during thermal treatment.

6. The process as claimed in any one of the preceding claims, **characterised in that** since one of the semiconductor elements is a thin film (32, 55), the process comprises a preliminary step consisting of defining this thin film as a superficial layer of a substrate intended to be separated from the rest of the substrate.

7. The process as claimed in Claim 6, **characterised in that** during the preliminary step the substrate is formed by stacking a support (30), a sacrificial layer (31) and the thin film (32), the thin film being separated from the rest of the substrate after bonding is completed by dissolving of the sacrificial layer (31).

8. The process as claimed in Claim 6, **characterised in that** during the preliminary step the thin film is delimited in a substrate (50) by a layer of microcavities (51) obtained by ionic implanting, separation of the thin film from the rest of the substrate being consecutive to thermal bonding treatment or specific thermal treatment or even to application of mechanical forces or to the combination of thermal treatment and the application of mechanical forces.

## Patentansprüche

1. Verfahren zur Herstellung einer elektrisch leitenden Verleimung zwischen einer Seite eines ersten Halbleiterelements aus SiC (10, 30, 55) und einer Seite eines zweiten Halbleiterelements aus SiC (12, 34, 53) mittels einer thermischen Behandlung, die darin besteht, mindestens eine Schicht aus Wolfram und eine Schicht aus Silizium auf die Seite des ersten Halbleiterelements und auf die Seite des zweiten Halbleiterelements aufzutragen;
- die Seiten mit Zwischenstellung der genannten Materialschichten aneinanderzudrücken,
- die thermische Behandlung mit einer Temperatur von über oder gleich 650°C durchzuführen,
wobei sich die aufgetragenen Schichten bei der thermischen Behandlung verbinden, um eine Schicht zu bilden, die eine elektrisch leitenden Verleimung zwischen den zwei Seiten absichert, wobei die auf die Seite des ersten Halbleiterelements aufgetragenen Schichten (11, 15, 33, 37, 52, 57) und die auf die Seite des zweiten Halbleiterelements aufgetragenen Schichten (13, 16, 35, 38, 54, 58) ausgewählt sind, um in solider Phase bei der thermischen Behandlung zu reagieren und ein thermisch stabiles Gemisch jeweils gegenüber dem ersten (10, 32, 55) und dem zweiten (12, 34, 53) Halbleiterelement zu bilden, wobei die thermische Behandlung kein Reaktionsprodukt zwischen den aufgetragenen Materialien und mindestens einem der Halbleiterelemente induziert.

2. Verfahren nach Anspruch 1, **dadurch gekennzeichnet, dass** eine der Materialschichten mit einer Überdicke derart aufgetragen wird, dass ein Teil dieser Schicht, der im Kontakt mit der anderen Materialschicht ist, mit der anderen aufgetragenen Materialschicht verbindet, um das stabile Gemisch zu bilden, wobei der andere Teil der mit einer Überdicke aufgetragenen Schicht, der mit dem Halbleiterelement im Kontakt ist, auf das sie aufgetragen wird, bei der ersten thermischen Behandlung mit diesem Halbleiterelement reagiert, um einen ohmschen Kontaktfilm zu bilden.

3. Verfahren nach Anspruch 1, **dadurch gekennzeichnet, dass** eine Oxidschicht zwischen den aufgetragenen Materialschichten vorgesehen ist, wobei das Oxid ausgewählt ist, um mit mindestens einem Material der aufgetragenen Schichten zu reagieren, wobei die Dicken der Oxidschicht und der Materialschicht, mit der das Oxid reagiert, derart sind, dass sich das gebildete Oxid in Form isolierter Ablagerungen darstellt, die die elektrisch leitenden Verleimung nicht spürbar beeinträchtigen.

4. Verfahren nach Anspruch 3, **dadurch gekennzeichnet, dass** die Oxidschicht auf eine der aufgetragenen Materialschichten aufgetragen wird oder auf die zwei.

5. Verfahren nach Anspruch 1, **dadurch gekennzeichnet, dass** das erste und zweite Halbleiterelement bei der thermischen Behandlung gegeneinander gedrückt werden.

6. Verfahren nach einem der vorangehenden Ansprüche, **dadurch gekennzeichnet, dass**, wobei eines der Halbleiterelemente ein dünner Film aus SiC (32, 55) ist, das Verfahren einen vorbereitenden Schritt umfasst, der darin besteht, diesen dünnen Film als Oberflächenschicht eines Substrats zu definieren, die dazu bestimmt ist, vom restlichen Substrat getrennt zu werden.

7. Verfahren nach Anspruch 6, **dadurch gekennzeichnet, dass** bei dem vorbereitenden Schritt das Substrat durch Schichtstapeln eines Trägers (30), einer Opferschicht (31) und des dünnen Films (32) gebildet wird, wobei die Trennung des dünnen Films vom restlichen Substrat nach Durchführung der Verleimung durch Auflösen der Opferschicht (31) erfolgt.

8. Verfahren nach Anspruch 6, **dadurch gekennzeichnet, dass** bei dem vorbereitenden Schritt der dünne Film in einem Substrat (50) durch eine Schicht mit Mikrovertiefungen (51) begrenzt ist, die durch Ionenimplantation hergestellt wird, wobei die Trennung des dünnen Films vom restlichen Substrat nach der thermische Verleimungsbehandlung oder einer speziellen thermischen Behandlung oder auch der Anwendung mechanischer Kräfte oder der Kombination einer thermischen Behandlung und der Anwendung mechanischer Kräfte erfolgt.
